# EUROPEAN PATENT SPECIFICATION

(11) **EP 1 068 632 B1**
(45) Date of publication and mention of the grant of the patent: **15.11.2006**
(21) Application number: 99915049.3
(22) Date of filing: 26.03.1999
(51) Int. Cl.: H01J 37/32

(54) **CONTAMINATION CONTROLLING METHOD AND PLASMA PROCESSING CHAMBER**
PLASMA-BEARBEITUNGS-KAMMER UND VERFAHREN ZUR KONTROLLE VON VERUNREINIGUNGEN
PROCEDE DE CONTROLE DE CONTAMINATION ET CHAMBRE DE TRAITEMENT AU PLASMA

(30) Priority: 31.03.1998 US 50902
(43) Date of publication of application: 17.01.2001
(73) Proprietor: LAM RESEARCH CORPORATION, Fremont, CA 94538 (US)
(72) Inventor: SCHOEPP, Alan, M., Ben Lomond, CA 95005 (US); WICKER, Thomas, E., Reno, NV 89511 (US); MARASCHIN, Robert, A., Cupertino, CA 95014 (US)
(74) Representative: Brookes Batchellor LLP
(86) International application number: PCT/US1999/006658
(87) International publication number: WO 1999/050886

(56) References cited:
- EP-A- 0 779 651
- EP-A- 0 821 397
- EP-A- 0 826 646
- US-A- 5 006 220
- US-A- 5 085 727
- US-A- 5 182 059
- US-A- 5 198 718
- US-A- 5 292 399
- US-A- 5 304 279
- US-A- 5 441 568
- US-A- 5 556 501

## Description

### Field of the Invention

The invention relates to improvements in a plasma processing chamber and to a method of processing a substrate in the plasma processing chamber such as by plasma etching an oxide layer on a semiconductor wafer.

### Background of the Invention

Vacuum processing chambers are generally used for chemical vapor depositing (CVD) and etching of materials on substrates by supplying process gas to the vacuum chamber and application of an RF field to the gas. Examples of parallel plate, transformer coupled plasma (TCP™, also called ICP), and electron-cyclotron resonance (ECR) reactors are disclosed in commonly owned U.S. Patent Nos. 4,340,462; 4,948,458; and 5,200,232. The substrates are held in place within the vacuum chamber during processing by substrate holders.

Conventional substrate holders include mechanical clamps and electrostatic clamps (ESC). Examples of mechanical clamps and ESC substrate holders are provided in commonly owned U.S, Patent No. 5,262,029 and commonly owned U.S. Patent No. 5,671,116 filed on March 10, 1995. Substrate holders in the form of an electrode can supply radiofrequency (RF) power into the chamber, as disclosed in U.S. Patent No. 4,579,618. According to U.S. Patent No. 5,292,399, metal surfaces of wafer support and clamping ring mechanisms can be covered with insulating material to prevent erosion by the plasma and electrically conductive material can be used to reduce arcing due to charge build-up on such insulation surfaces.

Plasma processing systems wherein an antenna coupled to a radio frequency (RF) Source energize gas into a plasma state within a process chamber are disclosed in US Patent No's 4,948,458; 5,198,718; 5,241,245 and 5,401,350. In such systems the antenna is located outside the process chamber and the RF energy is supplied to the chamber through a dielectric window. Such process systems can be used for a variety of semiconductor processing applications such as etching, deposition, resist stripping, etc.

The applicant may be further enlightened as to the state of the art by reference to EP-A-0 821 397 which discloses a silicon carbide composite article particularly useful for plasma reactors and exhibiting steps and components corresponding to those recited in the precharacterising parts of claims 1 and 12 herein.

### Summary of Invention

An object of the invention is to reduce metal and/or particle contamination of plasma processed substrates when substrates are processed continuously. US-A-5,085,727 describes a method of processing a substrate and a process chamber for carrying out the method.

Accordingly the present invention provides a method of processing a substrate according to claim 1.

The processing chamber can include a substantially planar antenna and the process gas can be energised into the plasma state by supplying RF power to the antenna. The plasma can comprise a high density plasma and the substrates can be processed by etching an oxide layer on the substrates with the high density plasma while supplying an RF bias to the substrates.

According to a further aspect of the present invention there is provided a plasma processing chamber according to claim 12.

At least one further exposed surface composed of a silicon carbide based material can be provided and in this case the further surface is defined by a gas distribution plate supplying the process gas to the process chamber, a perforated baffle extending between the substrate holder and the liner and/or the focus ring surrounding the substrate. The liner the distribution plate the baffle and/or the focus ring consist essentially of hot-pressed sintered , CVD or reaction bonded SiC or a composite wherein a coating of SiC forms the exposed surface thereof The chamber can further include a dielectric window adjacent the gas distribution plate and the RF energy source or planar antenna can be adjacent the window to supply power through the window to energize the process gas in the processing chamber into a plasma state. The antenna can be arranged such that the gas outlets in the gas distribution plate are not directly between the substrate holder and the antenna. The dielectric window can have a substantially uniform thickness and substantially planar configuration and the gas distribution plate can have a substantially uniform thickness and substantially planar configuration.

### Brief Description of the Drawings

The invention will be described in greater detail with reference to the accompanying drawings in which like elements bear like reference numerals, and wherein:
FIG. 1 is a cross sectional view of a vacuum processing chamber constructed in accordance with the invention;
FIG. 2 is a cross sectional view of a modified vacuum processing chamber according to the invention wherein the liner is cylindrical in shape;
FIG. 3 is a cross sectional view of a portion of a modified vacuum processing chamber in accordance with the invention wherein the liner includes a cylindrical portion and a conical portion; and
FIG. 4 is a top view of a baffle ring usable in the processing chamber according to the invention.

### Detailed Description of the Preferred Embodiments

In plasma gas processing of semiconductor substrates such as silicon wafers, high density plasmas typically cause a relatively high erosion rate of chamber interior surfaces they contact due to physical and/or chemical sputtering. This is an important issue in applications for wafer processing in the semiconductor industry, due to the sensitivity of devices on the wafer to contamination from metals which are deep impurities in silicon such as nickel and iron, alkali metals such as sodium and potassium that are mobile ions in the gate oxide of devices causing unstable threshold voltage, and metals such as aluminum which cause leakage currents in device junctions resulting, for example, in short refresh times in DRAM memory cells. Because of this, the surfaces of the chamber exposed to the high density plasma in such wafer processing tools are normally covered with a nonmetallic material such as alumina or quartz.

Alumina and quartz are dielectric materials which present a high impedance to the RF current used to sustain the plasma, and the RF current used to induce a bias voltage on the wafer. As a result, the RF current through the plasma does not have a good ground path and can become unstable, resulting in non-repeatable etch results. Moreover, charge build-up on the dielectric materials can cause arcing and thus localized sputtering of the dielectric materials.

The present invention uses a liner acting as a side wall of the processing chamber as a separate component with a surface of silicon carbide (SiC) as a consumable chamber surface material which reduces metal and/or particle contamination of the processed substrates. The liner component is electrically conductive so that when it is in contact with the plasma it presents a good ground path for the RF current. The SiC liner provides a grounded surface which is resistant to erosion from ion bombardment and reduces plasma potential on surfaces in the chamber. The liner can consist entirely of SiC, comprise a SiC coated material such as SiC coated graphite, or principally SiC with 10 to 20% Si added to fill porosity in reaction bonded SiC. The SiC also etches at a slow rate by the plasma making the component a cost effective consumable part. Moreover, because the SiC is of high purity, wafer contamination resulting from chemical sputtering of the SiC by the plasma can be minimized. Further, the grounded SiC liner component can reduce sputtering of other surfaces in the chamber by causing a reduction in the plasma potential and hence ion bombardment energy to these non-silicon carbide surfaces. To the extent the SiC component replaces alumina as a chamber surface, aluminium contamination of wafers can be reduced. Finally, the SiC component provides a very stable plasma potential so that etch results are more repeatable within an individual chamber and from chamber to chamber.

The invention provides improvements in reducing contamination of substrates such as semiconductor wafers, flat panel display substrates, and the like. The reduced contamination can be enhanced by utilizing silicon carbide as the material for additional members with exposed surfaces adjacent the substrate being processed in the chamber. Such additional members include non-electrically driven chamber parts such as focus rings, gas distribution plates, baffle plates and the like. The liner can provide a better RF return path for the powered electrode (bottom electrode) in the wafer support.

In plasma etching, features can be etched into layers of various materials on substrates such as silicon wafers. In such etching processes, a gas distribution plate can be used to control the spatial distribution of gas flow in the volume of the reactor above the plane of the wafer. In the TCP 9100™ plasma etching reactor available from LAM Research Corporation, the gas distribution plate is a circular plate situated directly below the TCP™ window which is also the vacuum sealing surface at the top of the reactor in a plane above and parallel to the wafer. The gas distribution plate is sealed using an O-ring to a gas distribution ring located at the periphery of the gas distribution plate. The gas distribution ring feeds gas from a source into the volume defined by the gas distribution plate, an inside surface of a window underlying a coil supplying RF energy into the reactor, and the gas distribution ring. The gas distribution plate contains an array of holes of a specified diameter which extend through the plate. The spatial distribution of the holes through the gas distribution plate can be varied to optimize etch uniformity of the layers to be etched, e.g., a photoresist layer, a silicon dioxide layer and an underlayer material on the wafer. The cross-sectional shape of the gas distribution plate can be varied to manipulate the distribution of RF power into the plasma in the reactor. The gas distribution plate material must be a dielectric to enable coupling of this RF power through the gas distribution plate into the reactor. Further, the material of the gas distribution plate must be highly resistant to chemical sputter-etching in environments such as oxygen or a hydrofluorocarbon gas plasma in order to avoid breakdown and the resultant particle generation associated therewith. Moreover, the material of the gas distribution plate should have low levels of contaminants that might otherwise affect performance of devices on the wafer. According to a preferred embodiment of the invention, the gas distribution plate can be of specially prepared silicon carbide having high resistivity.

It has surprisingly and unexpectedly been found that use of silicon carbide for interior chamber surfaces provides performance results which far exceed other materials such as aluminium nitride and alumina.

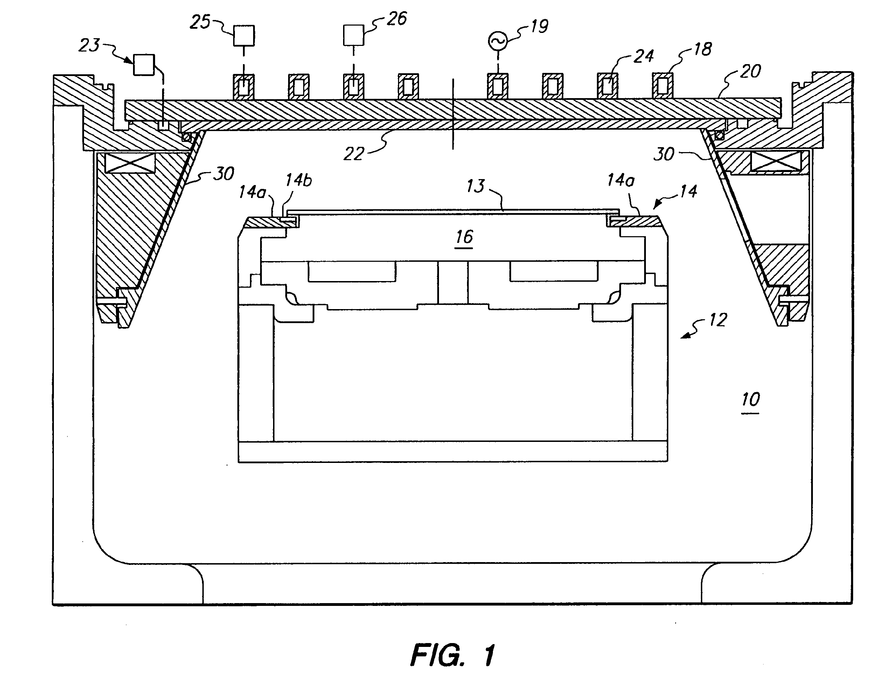

A vacuum processing chamber according to one embodiment of the present invention is illustrated in FIG. 1. The vacuum processing chamber 10 includes a substrate holder 12 providing an electrostatic clamping force to a substrate 13 as well as an RF bias to a substrate while it is He backcooled. A focus ring 14 comprising a dielectric outer ring 14a and a SiC inner ring 14b confines plasma in an area above the substrate. A source of energy for maintaining a high density (e.g., 10¹¹-10¹² ions/cm³) plasma in the chamber such as an antenna 18 powered by a suitable RF source and suitable RF impedance matching circuitry inductively coupled RF energy into the chamber 10 so as to provide a high density plasma. The chamber includes suitable vacuum pumping apparatus for maintaining the interior of the chamber at a desired pressure (e.g., below 50 mTorr, typically 1-20 mTorr). A substantially planar dielectric window 20 of uniform thickness provided between the antenna 18 and the interior of the processing chamber 10 forms the vacuum wall at the top of the processing chamber 10. A gas distribution plate 22 is provided beneath window 20 and includes openings such as circular holes for delivering process gas from the gas supply 23 to the chamber 10. In accordance with the invention, a separate conical liner 30 with an exposed surface acting as a side wall of the chamber 10 and composed of a silicon carbide based material extends from the gas distribution plate and surrounds the substrate holder 12. The liner 30 is electrically grounded to provide a path for the RF energy. The antenna 18 can be provided with a channel 24 through which a temperature control fluid is passed via inlet and outlet conduit 25, 26. However, the antenna 18 and/or window 20 could be cooled by other techniques such as by blowing air over the antenna and window, passing a cooling medium through or in heat transfer contact with the window and/or gas distribution plate, etc.

In operation, a wafer is positioned on the substrate holder 12 and is typically held in place by an electrostatic clamp, a mechanical clamp, or other clamping mechanism when He backcooling is employed. Process gas is then supplied to the vacuum processing chamber 10 by passing the process gas through a gap between the window 20 and the gas distribution plate 22. Suitable gas distribution plate arrangements (i.e., showerhead) arrangements are disclosed in commonly owned U.S. Patent Nos. 5,824,605; 6,048,798 and 5,863,376, the disclosures of which are hereby incorporated by reference. For instance, while the window and gas distribution plate arrangement in FIG. 1 are planar and of uniform thickness, non-planar and/or non-uniform thickness geometries can be used for the window and/or gas distribution plate. A high density plasma is ignited in the space between the substrate and the window by supplying suitable RF power to the antenna 18. A temperature control fluid can also be passed through the channel 24 in the antenna 18 to maintain the antenna 18, window 20 and gas distribution plate 22 at a temperature below a threshold temperature such as less than 120°C, preferably below 90°C and more preferably below 80°C.

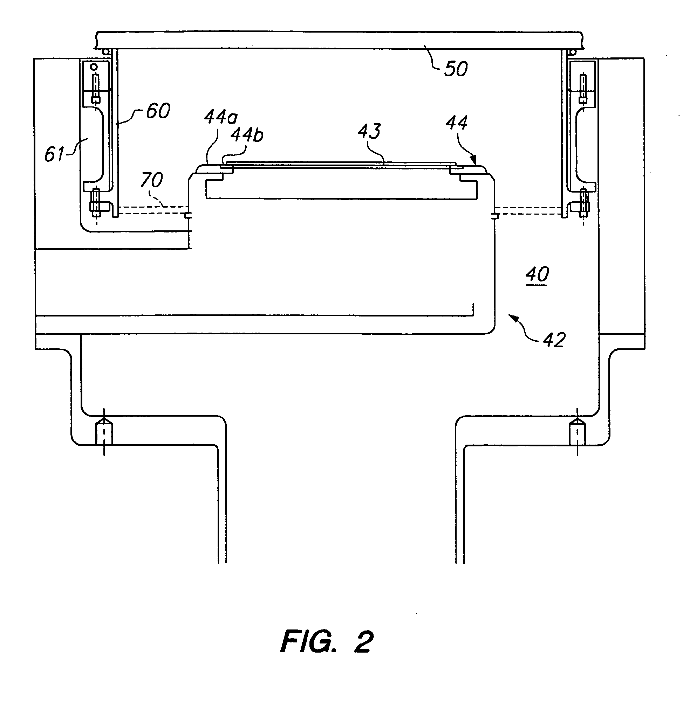

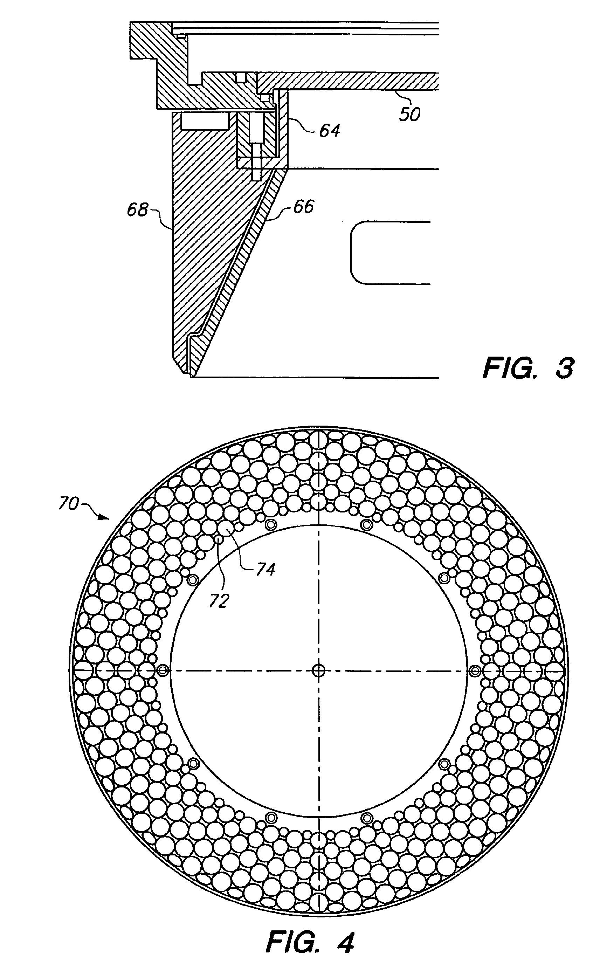

A vacuum processing chamber according to another embodiment of the present invention is illustrated in FIG. 2. The vacuum processing chamber 40 includes a substrate holder 42 providing an electrostatic clamping force to a substrate 43 as well as an RF bias to a substrate supported thereon. A focus ring 44 having outer dielectric portion 44a and inner SiC portion 44b confines plasma in an area above the substrate while it is He backcooled. A source of energy for maintaining a high density (e.g. 10¹¹-10¹² ions/cm³) plasma in the chamber such as an antenna (not shown) powered by a suitable RF source and suitable RF impedance matching circuitry inductively couples RF energy into the chamber 40 so as to provide a high density plasma. The chamber includes suitable vacuum pumping apparatus for maintaining the interior of the chamber at a desired pressure (e.g. below 50 m Torr, typically 1-20 mTorr). A substantially planar dielectric window of uniform thickness can be provided between the antenna and the interior of the processing chamber 40 and to form the vacuum wall at the top of the processing chamber 40. A gas distribution plate, commonly called a showerhead 50, is provided beneath the window and includes a plurality of openings such as circular holes (not shown) for delivering process gas supplied by a suitable gas supply to the processing chamber 40. A cylindrical liner 60 equivalent to the liner 30 in FIG.1 extends from the gas distribution plate and surrounds the substrate holder 42. A baffle ring 70 extends between the substrate holder 42 and the liner 60. The liner 60 and/or the baffle ring 70 can be heated by a heating member 61 which can be heated by any suitable technique such as resistance heating, a heated fluid, etc. Details of the baffle ring 70 are shown in Fig. 4 wherein it can be seen that the baffle ring 70 includes small holes 72 and large holes 74 for passage of gases and by-products to a vacuum pump connected to the bottom of the chamber.

In another embodiment, as shown in Fig. 3, a modified liner 62 can include a cylindrical portion 64 and a conical portion 66. In this embodiment, a heater 68 includes resistive elements (not shown) which are used to maintain the portion 64 and/or portion 66 at a desired temperature.

Substrates which are etched in an oxide etching process generally include an underlayer, an oxide layer which is to be etched, and a photoresist layer formed on top of the oxide layer. The oxide layer may be one of SiO₂, BPSG, PSG, or other oxide material. The underlayer may be Si, TiN, silicide, or other underlying layer or substrate material. The etch selectivity, which is the etch rate of the layer to be etched compared to the photoresist etch rate is preferably around 4:1 or higher. The etch selectivity of the oxide layer compared to the underlayer is preferably greater than the oxide:photoresist etch selectively, e.g., 40:1.

According to the invention, the silicon carbide chamber liner 30,60,62 and optionally the focus ring 44, the baffle ring 70 and/or gas distribution plate 22,50, also with exposed surface composed of silicon carbide reduces metal and/or particle contamination of substrates during processing such as etching of dielectric materials such as silicon dioxide (e.g., doped or undoped TEOS, BPSG, USG (undoped spin-on-glass), thermal oxide, plasma oxide, etc.) typically overlying a conductive layer such as silicon, polysilicon, silicide, titanium nitride, aluminum or a non-conductive material such as silicon nitride. According to the invention, features (such as contact holes, vias, trenches, etc.) can be provided having dimensions of 0.5 µm and below and aspect ratios ranging from 2:1 to 7:1 can be etched from substrate to substrate during sequential batch processing of substrates such as semiconductor wafers (e.g., 25 or more consecutive wafers) while maintaining particle contamination of the wafers below acceptable levels.

During oxide etching, the chamber pressure is typically below 300 mTorr, preferably 1-40 mTorr, the antenna is powered at 200-5000 watts, preferably 300-2500 watts, the RF bias is ≤ 6000 watts, preferably 1000-2500 watts, and the He backpressure is 5-40 Torr, preferably 7-20 Torr. The process gas can include 10-200 sccm CHF₃, 10-100 sccm C₂HF₅ and/or 10-100 sccm C₂F₆.

By making the silicon carbide liner 30, 60, 62 as a separate piece attachable to the reaction chamber by any suitable technique, for instance, bolting to an electrically grounded part of the chamber thereby providing grounding of the liner the liner can be replaced. Alternatively, silicon carbide can be additionally provided as a coating on metal and/or ceramic parts of the chamber. In the case where the additional silicon carbide member is the gas distribution plate, the silicon carbide preferably has a resistivity high enough to allow an RF antenna to couple RF energy into the chamber. For instance, the silicon carbide can be hot pressed to obtain resistivity values on the order of about 5 x 10⁴ Ω·cm. For even higher resistivities, SiC powder can be doped with a suitable additive or sintered in a nitrogen atmosphere to form Si₃N₄ in grain boundaries of the silicon carbide and thus raise the resistivity to values such as 1 x 10⁸ Ω·cm. In making a gas distribution plate, suitable gas passages and outlet holes can be provided in a green ceramic material which is later sintered to form a unitary plate. In order to prevent plasma from striking in the passages and/or holes, the dimensions of the passages and holes are preferably small enough to avoid conditions under which plasma would form during flow of process gas and powering of the antenna.

Principally the liner and optionally the focus ring, baffle plate and/or gas distribution plate can be made of various blends of silicon carbide based powder material having a predominant amount of silicon carbide. For instance, the total amount of silicon and carbon is typically at least 90 wt %, preferably ≥ 95 wt %, and more preferably ≥ 99 wt %. For example, the SiC member may include up to about 0.5 % B to aid sintering of the SiC powder. The SiC member may include an excess of Si such as up to about 35 wt % free Si and/or Si₃N₄. The silicon carbide material can be made by any suitable process such as hot pressing, sintering, reaction bonding (e.g., wherein SiC is infiltrated with molten Si), etc. For the liner and optionally the focus ring and/or baffle, the silicon carbide preferably has a low resistivity such as below 200 Ω·cm. The resistivity is much higher, however, when the additional SiC member is used for a window and/or gas distribution plate used in conjunction with an RF antenna. If a different RF source is used, the window/gas distribution plate can be replaced with a low resistivity SiC member. In order to avoid metal contamination during processing of semiconductor substrates, the SiC member is preferably made by a process which avoids the presence of such metals in the SiC member. The silicon and carbon are preferably present in amounts sufficient achieve a nominal SiC stoichiometry. Such mixtures can be formed into a desired shape, sintered and machined to desired tolerances and/or surface finishes on surfaces such as vacuum sealing surfaces. The SiC member preferably is highly dense, e.g., having a density over 3.1 g/cm³.

In the case where the SiC member is formed by CVD, it is preferable to deposit enough SiC to form a bulk member. For instance, SiC can be deposited on a graphite mandrel and when a desired thickness of SiC is achieved, the graphite mandrel can be etched away leaving a highly pure and highly dense SiC member.

The silicon carbide liner and other optional members according to the invention provides dramatic reduction in particle count on wafers processed during oxide etching and oxygen cleaning steps. The silicon carbide liner and other optional members also reduces particle contamination during an ashing process wherein 750 sccm oxygen gas can be run for 10 seconds with the TCP™ power at 650 W, the bottom electrode at 750 W and the pressure at 10 mTorr. Compared to an alumina liner which is attacked during the etching and oxygen cleaning steps and can liberate aluminum which could contaminate wafers, a silicon carbide liner provides better contamination performance since there is preferably less than 200 ppm A1 in the silicon carbide material. Moreover, during processing such as plasma etching, by-products produced as a result of erosion of the SiC are volatile and thus do not contribute to adding particles on the wafers and the liberated elements Si and C are not detrimental to wafer processing.

The foregoing has described the principles, preferred embodiments and modes of operation of the present invention. However, the invention should not be construed as being limited to the particular embodiments discussed. Thus, the above-described embodiments should be regarded as illustrative rather than restrictive, and it should be appreciated that variations may be made in those embodiments by workers skilled in the art without departing from the scope of the present invention as defined by ,the following claims.

## Claims

1. A method of processing a substrate (13, 43) comprising the steps of:
(a) placing a substrate (13, 43) on a substrate holder (12, 42) in a processing chamber (10, 40), the processing chamber (10, 40) having at least one exposed surface adjacent the substrate (13, 43) composed of a silicon carbide based material;
(b) processing the substrate (13, 43) by supplying process gas to the processing chamber and energizing the process gas into a plasma state in the processing chamber by the supply of RF energy, the exposed surface being exposed to the plasma;
(c) removing the substrate (13, 43) from the processing chamber; and
(d) consecutively processing additional substrates in the processing chamber by repeating steps (a-c) while minimizing particle contamination of the substrates during the processing step as a result of reduction of plasma potential on the silicon carbide surface and/or reduced sputtering of non-silicon carbide chamber interior surfaces; the exposed surface is defined by a liner (30,60,62) of the processing chamber,
**characterised by**:
using a liner (30,60,62) formed entirely of CVD SiC to provide a highly uniform temperature distribution across the exposed surface area thereof during the processing step,
and by electrically grounding the liner (30,60,62) to provide a return path for RF during the processing step
and by
heating the liner (30,60,62) by means of a heater.

2. The method according to claim 1 wherein liner (30,60,62) piece is attached by bolting.

3. The method according to claim 1 or 2, wherein the processing chamber includes a substantially planar antenna (18) which energizes the process gas into the plasma state by supplying RF power to the antenna and the process gas comprising one or more hydrofluorocarbon gases.

4. The method according to claim 1, wherein the plasma comprises a high density plasma and the substrates are processed by etching an oxide layer on the substrates with the high density plasma while supplying an RF bias to the substrates.

5. The method according to any one of the preceding claims, wherein there is at least one further exposed surface composed of a silicon carbide based material and the further exposed surface is defined by a gas distribution plate (22, 50) supplying the process gas to the processing chamber, a perforated baffle (70) extending between the substrate holder and the liner (30,60,62) and/or a focus ring (14, 14b, 44, 44b) surrounding the substrate (13, 43).

6. The method according to any one of claims 1 to 4, wherein the liner (30,60,62) is heated to a temperature above room temperature during the processing step and a baffle (70) extends between the substrate holder and the liner (30,60,62), the liner (30,60,62) surrounding the substrate holder and the baffle comprising a foraminous ring.

7. The method according to claim 6, wherein the baffle (70) also has an exposed surface composed of a silicon carbide based material.

8. The method according to any one of claims 1 to 4, wherein the process gas is supplied by a gas distribution plate (22, 50) also having an exposed surface composed of a silicon carbide based material and having a resistivity high enough to make the silicon carbide an insulating material.

9. The method according to any one of claims 1 to 8, wherein the heated member surrounds the liner (30, 60, 62) to maintain the liner (30, 60, 62) at a desired temperature.

10. The method according to any one of claims 1 to 9, wherein the liner (30,60,62), the distribution plate, the baffle and/or the focus ring consists essentially of hot-pressed, sintered, CVD or reaction bonded SiC or a composite wherein a coating of SiC forms the exposed surface thereof.

11. The method according to any one of claims 1 to 10, wherein the liner (30,60,62) has a resistivity below 200 Ω·cm.

12. A plasma processing chamber comprising:
a substrate holder (12, 42) for supporting a substrate (13, 43) within an interior of the processing chamber;
an exposed surface adjacent the substrate (13, 43) composed of silicon carbide based material;
a gas supply (23) for supplying process gas to the interior of the processing chamber; and
an energy source (18) supplying RF energy into the interior of the processing chamber and energizing the process gas into a plasma state for processing a substrate (13, 43), the silicon carbide surface minimizing particle contamination of substrates during plasma processing thereof as a result of reduction of plasma potential on the silicon carbide surface and/or reduced sputtering of non-silicon carbide chamber interior surfaces; wherein the exposed surface is defined by a liner (30,60,62)
**characterized in that** the liner (30,60,62)
is formed entirely of CVD SiC to provide a highly uniform temperature distribution across the exposed surface thereof during the process,
the liner (30,60,62) is electrically grounded to provide a return path for the RF during the processing step and
a heater (68) is provided to heat the liner (30,60,62).

13. A plasma processing chamber according to claim 12 wherein the liner (30,60,62) piece is attached by bolts.

14. The plasma processing chamber according to one of claims 12 or 13, wherein the heater (68)is provided by a heated member which surrounds the liner (30,60,62) and maintains the liner (30,60,62) at the desired temperature.

15. The plasma processing chamber according to one of claims 12 to 14, wherein the processing chamber includes a dielectric window (20) and the energy source comprises a substantially planar antenna (18) adjacent the window, the antenna supplying RF power through the window to energize process gas in the processing chamber into a plasma state.

16. The plasma processing chamber according to one of claims 12 to 15, wherein at least one further exposed surface composed of a silicon carbide based material is provided, the further exposed surface being defined by a gas distribution plate (22, 50) supplying the process gas, a focus ring (14, 14b, 44, 44b) surrounding the substrate holder and/or a perforated baffle (70) between the substrate holder and the liner (30,60,62).

17. The plasma processing chamber according to claim 16, wherein the component with the further exposed surface has a resistivity of at least 5 x 104 Ω·cm.

18. The plasma processing chamber according to any one of claims 12 to 17, wherein the liner (30,60,62) is composed of a cylindrical and/or conical portions.

19. The plasma processing chamber according to claim 16, wherein the further exposed surface is defined by the distribution plate which has a resistivity high enough to make the gas distribution plate an insulating material and the liner (30,60,62) having a resistivity low enough to make the liner (30,60,62) electrically conducting.

20. The plasma processing chamber according to any one of claims 12 to 19, wherein the liner (30,60,62), the distribution plate, the focus ring and/or the baffle consists essentially of hot-pressed, sintered, CVD or reaction bonded SiC or a composite, wherein a coating of SiC forms the exposed surface thereof.

21. The plasma processing chamber according to any one of claims 12 to 20, wherein the liner (30,60,62), the distribution plate, the focus ring and/or the baffle has a density of at least 3.1 g/cm3 and includes at least 99 wt% carbon and silicon.

## Patentansprüche

1. Verfahren zum Prozessieren eines Substrats (13, 43) umfassend die Verfahrensschritte:
(a) Platzieren eines Substrats (13, 43) auf einem Substrathalter (12, 42) in einer Prozesskammer (10, 40), wobei die Prozesskammer (10, 40) wenigstens eine an das Substrat (13, 43) angrenzende exponierte Oberfläche aus einem auf Siliziumcarbid basierenden Material aufweist;
(b) Prozessieren des Substrats (13, 43) durch das Zuführung von Prozessgas in das Innere der Prozesskammer verbunden mit einer energetischen Anregung des Prozessgases in den Plasmazustand indem Hochfrequenzenergie zugeführt wird, wobei die exponierte Oberfläche dem Plasma ausgesetzt ist;
(c) Entnahme des Substrats (13, 43) aus der Prozesskammer; und
(d) fortlaufendes Prozessieren weiterer Substrate in der Prozesskammer durch das Wiederholen der Prozessschritte (a-c), während gleichzeitig die Partikelkontamination der Substrate während des Prozessierens minimiert wird, indem das Plasmapotential auf der Siliziumcarbid-Oberfläche und/oder das Sputtern der Innenwandungen der Kammer, die nicht aus Siliziumcarbid bestehen, reduziert werden und wobei die exponierte Oberfläche durch eine Innenverkleidung (30, 60, 62) für die Prozesskammer festgelegt wird,
**dadurch gekennzeichnet, dass**
eine Innenverkleidung (30, 60, 62) verwendet wird, die vollständig aus mittels CVD abgeschiedenem SiC ausgebildet ist, um eine hochgradig gleichmäßige Temperaturverteilung während des Prozessierens über die exponierte Oberfläche zu erzielen,
die Innenverkleidung (30, 60, 62) elektrisch geerdet ist, um eine Ableitung für die Hochfrequenzspannung während des Prozessschritts zu Verfügung zu stellen, und
die Innerverkleidung (30, 60, 62) mittels eines Heizers beheizt wird.

2. Verfahren nach Anspruch 1, wobei die Innerverkleidung (30, 60, 62) als ein mit Schrauben befestigtes Bauteil ausgebildet ist.

3. Verfahren nach einem der Ansprüche 1 oder 2, wobei die Prozesskammer eine im Wesentlichen ebene Antenne (18) umfasst, die das Prozessgas zur Überführung in den Plasmazustand energetisch anregt, indem der Antenne Hochfrequenzenergie zugeführt wird und das Prozessgas Fluorkohlenwasserstoffgase enthält.

4. Verfahren nach Anspruch 1, wobei das Plasma ein Plasma hoher Dichte umfasst und die Substrate durch das Ätzen einer Oxidschicht auf den Substraten mit dem Plasma hoher Dichte und dem Anlegen einer Hochfrequenzspannung an die Substrate prozessiert wird.

5. Verfahren nach einem der voranstehenden Ansprüche, wobei wenigstens eine weitere exponierte Oberfläche vorliegt, die aus einem auf Siliziumcarbid basierenden Material besteht und die exponierte Oberfläche ferner durch eine Gasverteilerplatte (22, 50), die der Prozesskammer Prozessgas zuführt, und einer Prallplatte (70) (baffle) festgelegt wird, die sich zwischen dem Substrathalter und der Innenverkleidung (30, 60, 62) und/oder einem Fokussier-Ring (14, 14b, 44, 44b), der das Substrat (13, 43) umgibt, erstreckt.

6. Verfahren nach wenigstens einem der Ansprüche 1 bis 4, wobei die Innenverkleidung (30, 60, 62) während des Prozessschritts auf eine Temperatur oberhalb der Raumtemperatur aufgeheizt wird und eine Prallplatte (70) vorgesehen ist, die sich zwischen dem Substrathalter und der Innenverkleidung (30, 60, 62) erstreckt, und die Innenverkleidung (30, 60, 62) den Substrathalter umgibt und die Prallplatte einen Ring mit kleinen Öffnungen aufweist.

7. Verfahren nach Anspruch 6, wobei die Prallplatte (70) ebenfalls eine exponierte Oberfläche aufweist, die aus einem auf Siliziumcarbid basierenden Material besteht.

8. Verfahren nach wenigstens einem der Ansprüche 1 bis 4, wobei das Prozessgas über eine Gasverteilerplatte (22, 50) zugeführt wird, die ebenfalls eine exponierte Oberfläche aufweist, die aus einem auf Siliziumcarbid basierenden Material besteht und die einen spezifischen elektrischen Widerstand aufweist, der groß genug ist, um dem Siliziumcarbid isolierende Eigenschaften zu verleihen.

9. Verfahren nach wenigstens einem der Ansprüche 1 bis 8, wobei ein beheiztes Bauteil die Innenverkleidung (30, 60, 62) umgibt, um die Innenverkleidung (30, 60, 62) auf einer gewünschten Temperatur zu halten.

10. Verfahren nach wenigstens einem der Ansprüche 1 bis 9, wobei die Innenverkleidung (30, 60, 62), die Prallplatte und/oder der Fokussier-Ring im Wesentlichen aus einem heißgepressten, gesinterten, mittels eines CVD-Verfahrens hergestellten oder eines reaktionsgebundenen SiC oder eines Kompositmaterials bestehen, dessen Beschichtung aus SiC eine exponierte Oberfläche bildet.

11. Verfahren nach einem der Ansprüche 1 bis 10, wobei die Innenverkleidung (30, 60, 62) einen spezifischen elektrischen Widerstand unterhalb 200 Ω · cm aufweist.

12. Plasmaprozesskammer, umfassend
einen Substrathalter (12, 42) zum Haltern eines Substrats (13, 43) innerhalb einer Prozesskammer;
eine an das Substrat (13, 43) angrenzende exponierte Oberfläche bestehend aus einem auf Siliziumcarbid basierenden Material;
eine Gasversorgung (23) zur Zuführung von Prozessgas in das Innere der Prozesskammer; und
eine Energiequelle (18) zur Versorgung des Innenraums der Prozesskammer mit Hochfrequenzenergie zur energetischen Anregung des Prozessgases in den Plasmazustand für die Prozessierung des Substrats (13, 43), wobei die Siliziumcarbid-Oberfläche die Partikelkontamination des Substrats während der Plasmaprozessierung minimiert, indem das Plasmapotential auf der Siliziumcarbid-Oberfläche und/oder das Sputtern der Innenwandungen der Kammer, die nicht aus Siliziumcarbid bestehen, reduziert werden und wobei die exponierte Oberfläche durch eine Innenverkleidung (30, 60, 62) festgelegt wird,
**dadurch gekennzeichnet, dass**
die Innenverkleidung (30, 60, 62) vollständig aus mittels CVD abgeschiedenem SiC ausgebildet ist, um eine hochgradig gleichmäßige Temperaturverteilung während der Prozessierung über die exponierte Oberfläche zu erzielen,
die Innenverkleidung (30, 60, 62) elektrisch geerdet ist, um eine Ableitung für die Hochfrequenzspannung während des Prozessschritts zu Verfügung zu stellen, und
ein Heizer (68) vorgesehen ist, der dem Beheizen der Innerverkleidung (30, 60, 62) dient.

13. Plasmaprozesskammer nach Anspruch 12, wobei die Innerverkleidung (30, 60, 62) als ein mit Schrauben befestigtes Bauteil ausgebildet ist.

14. Plasmaprozesskammer nach einem der Ansprüche 12 oder 13, wobei der Heizer (68) ein die Innenverkleidung (30, 60, 62) umgebendes beheiztes Bauteil ist, das die Innenverkleidung (30, 60, 62) auf einer gewünschten Temperatur hält.

15. Plasmaprozesskammer nach einem der Ansprüche 12 bis 14, wobei die Prozesskammer ein dielektrisches Fenster (20) umfasst und die Energiequelle eine im Wesentlichen ebene Antenne (18) angrenzend an das Fenster umfasst, wobei die Antenne Hochfrequenzenergie zur energetischen Anregung des Prozessgases in der Prozesskammer in den Plasmazustand zuführt.

16. Plasmaprozesskammer nach einem der Ansprüche 12 bis 15, wobei wenigstens eine weitere exponierte Oberfläche bereitgestellt wird, die aus einem auf Siliziumcarbid basierenden Material besteht, wobei die weitere exponierte Oberfläche durch eine Gasverteilerplatte (22, 50) zur Zuführung von Prozessgas, einen Fokussier-Ring (14, 14b, 44, 44b), der den Substrathalter umgibt, und/oder eine zwischen dem Substrathalter und der Innenverkleidung (30, 60, 62) angeordnete perforierte Prallplatte (70) (Baffle) festgelegt wird.

17. Plasmaprozesskammer nach Anspruch 16, wobei das Bauteil mit der weiteren exponierten Oberfläche einen spezifischen elektrischen Widerstand von wenigstens 5 x 104 Ω · cm aufweist.

18. Plasmaprozesskammer nach wenigstens einem der Ansprüche 12 bis 17, wobei die Innenverkleidung (30, 60, 62) aus zylindrischen und/oder konischen Bereichen zusammengesetzt ist.

19. Plasmaprozesskammer nach Anspruch 16, wobei die weitere exponierte Oberfläche durch eine Verteilerplatte festgelegt ist, die einen spezifischen elektrischen Widerstand aufweist, welcher groß genug ist, um die Gasverteilerplatte isolierend auszubilden und die Innenverkleidung (30, 60, 62) einen solchen spezifischen elektrischen Widerstand aufweist, der niedrig genug ist, um die Innenverkleidung (30, 60, 62) elektrisch leitfähig zu machen.

20. Plasmaprozesskammer nach einem der Ansprüche 12 bis 19, wobei die Innenverkleidung (30, 60, 62), die Verteilerplatte, der Fokussier-Ring oder die Prallplatte im Wesentlichen aus einem heißgepressten, gesinterten, mittels CVD abgeschiedenen oder reaktionsgebundenen SiC oder einem Kompositmaterial mit einer Beschichtung aus SiC, welche die exponierte Oberfläche desselben bildet, bestehen.

21. Plasmaprozesskammer nach einem der Ansprüche 12 bis 20, wobei die Innenverkleidung (30, 60, 62), die Verteilerplatte, der Fokussier-Ring und/oder die Prallplatte eine Dichte von wenigstens 3,1 g/cm³ aufweisen und wenigstens 99 Gew.-% Kohlenstoff und Silizium enthalten.

## Revendications

1. Procédé de traitement d'un substrat (13, 43) comprenant les étapes consistant à :
(a) placer un substrat (13, 43) sur un support de substrat (12, 42) dans une chambre de traitement (10, 40), la chambre de traitement (10, 40) ayant au moins une surface à nu adjacente au substrat (13, 43) composée d'un matériau à base de carbure de silicium ;
(b) traiter le substrat (13, 43) en introduisant un gaz de traitement dans la chambre de traitement et en excitant le gaz de traitement à un état de plasma dans la chambre de traitement par l'application d'énergie radiofréquence, la surface à nu étant exposée au plasma ;
(c) retirer le substrat (13, 43) de la chambre de traitement ; et
(d) traiter d'autres substrats de manière consécutive dans la chambre de traitement en répétant les étapes (a) à (c) tout en minimisant la contamination particulaire des substrats pendant l'étape de traitement en raison de la réduction du potentiel de plasma sur la surface de carbure de silicium et/ou de la pulvérisation cathodique réduite des surfaces internes de la chambre non constituées de carbure de silicium ; la surface à nu étant définie par une chemise (30, 60, 62) de la chambre de traitement,
**caractérisé par** :
- l'utilisation d'une chemise (30, 60, 62) entièrement formée de SiC par CVD pour obtenir une distribution de température hautement uniforme sur toute la zone de surface à nu de celle-ci pendant l'étape de traitement,
- et la mise à la masse électrique de la chemise (30, 60, 62) pour fournir un chemin de retour à l'énergie radiofréquence pendant l'étape de traitement
- et le chauffage de la chemise (30, 60, 62) au moyen d'un dispositif de chauffage.

2. Procédé selon la revendication 1, dans lequel la pièce de chemise (30, 60, 62) est fixée par boulonnage.

3. Procédé selon la revendication 1 ou 2, dans lequel la chambre de traitement comprend une antenne essentiellement plane (18) qui excite le gaz de traitement à l'état de plasma en envoyant une énergie radiofréquence à l'antenne et le gaz de traitement comprenant un ou plusieurs gaz hydrofluorocarbonés.

4. Procédé selon la revendication 1, dans lequel le plasma comprend un plasma haute densité et les substrats sont traités par gravure d'une couche d'oxyde sur les substrats à l'aide du plasma haute densité tout en appliquant une polarisation radiofréquence aux substrats.

5. Procédé selon l'une quelconque des revendications précédentes, dans lequel au moins une autre surface à nu est composée d'un matériau à base de carbure de silicium et l'autre surface à nu est définie par une plaque de distribution de gaz (22, 50) introduisant le gaz de traitement dans la chambre de traitement, un déflecteur perforé (70) s'étendant entre le support de substrat et la chemise (30, 60, 62) et/ou une bague de focalisation (14, 14b, 44, 44b) entourant le substrat (13, 43).

6. Procédé selon l'une quelconque des revendications 1 à 4, dans lequel la chemise (30, 60, 62) est chauffée à une température supérieure à la température ambiante pendant l'étape de traitement et un déflecteur (70) s'étend entre le support de substrat et la chemise (30, 60, 62), la chemise (30, 60, 62) entourant le support de substrat et le déflecteur comprenant une bague foraminée.

7. Procédé selon la revendication 6, dans lequel le déflecteur (70) comprend également une surface à nu composée d'un matériau à base de carbure de silicium.

8. Procédé selon l'une quelconque des revendications 1 à 4, dans lequel le gaz de traitement est introduit par une plaque de distribution de gaz (22, 50) ayant également une surface à nu composée d'un matériau à base de carbure de silicium et ayant une résistivité suffisamment élevée pour faire du carbure de silicium un matériau isolant.

9. Procédé selon l'une quelconque des revendications 1 à 8, dans lequel l'élément chauffé entoure la chemise (30, 60, 62) pour maintenir la chemise (30, 60, 62) à une température souhaitée.

10. Procédé selon l'une quelconque des revendications 1 à 9, dans lequel la chemise (30, 60, 62), la plaque de distribution, le déflecteur et/ou la bague de focalisation se composent essentiellement de SiC déposé par CVD, fritté, pressé à chaud ou lié par réaction ou d'un composite dans lequel un revêtement de SiC forme la surface à nu de ceux-ci.

11. Procédé selon l'une quelconque des revendications 1 à 10, dans lequel la chemise (30, 60, 62) a une résistivité inférieure à 200 Ω.cm.

12. Chambre de traitement par plasma comprenant :
- un support de substrat (12, 42) pour supporter un substrat (13, 43) à l'intérieur de la chambre de traitement ;
- une surface à nu adjacente au substrat (13, 43) composée d'un matériau à base de carbure de silicium ;
- une alimentation en gaz (23) pour introduire un gaz de traitement à l'intérieur de la chambre de traitement ; et
- une source d'énergie (18) appliquant une énergie radiofréquence à l'intérieur de la chambre de traitement et excitant le gaz de traitement à un état de plasma pour traiter un substrat (13, 43), la surface de carbure de silicium minimisant la contamination particulaire des substrats pendant leur traitement par plasma en raison de la réduction du potentiel de plasma sur la surface de carbure de silicium et/ou de la pulvérisation cathodique réduite des surfaces internes de la chambre non constituées de carbure de silicium ; dans laquelle la surface à nu est définie par une chemise (30, 60, 62)
**caractérisée en ce que** :
- la chemise (30, 60, 62) est entièrement formée de SiC par CVD pour obtenir une distribution de température hautement uniforme sur toute la surface à nu de celle-ci pendant le traitement,
- la chemise (30, 60, 62) est électriquement mise à la masse pour fournir un chemin de retour à l'énergie radiofréquence pendant l'étape de traitement et
- un dispositif de chauffage (68) est prévu pour chauffer la chemise (30, 60, 62).

13. Chambre de traitement par plasma selon la revendication 12, dans laquelle la pièce de chemise (30, 60, 62) est fixée par des boulons.

14. Chambre de traitement par plasma selon l'une des revendications 12 ou 13, dans laquelle le dispositif de chauffage (68) est fourni par un élément chauffé qui entoure la chemise (30, 60, 62) et qui maintient la chemise (30, 60, 62) à la température souhaitée.

15. Chambre de traitement par plasma selon l'une des revendications 12 à 14, dans laquelle la chambre de traitement comprend une fenêtre diélectrique (20) et la source d'énergie comprend une antenne essentiellement plane (18) adjacente à la fenêtre, l'antenne appliquant une énergie radiofréquence à travers la fenêtre pour exciter le gaz de traitement dans la chambre de traitement à un état de plasma.

16. Chambre de traitement par plasma selon l'une des revendications 12 à 15, dans laquelle au moins une autre surface à nu composée d'un matériau à base de carbure de silicium est fournie, l'autre surface à nu étant définie par une plaque de distribution de gaz (22, 50) introduisant le gaz de traitement, une bague de focalisation (14, 14b, 44, 44b) entourant le support de substrat et/ou un déflecteur perforé (70) entre le support de substrat et la chemise (30, 60, 62).

17. Chambre de traitement par plasma selon la revendication 16, dans laquelle le composant ayant l'autre surface à nu a une résistivité d'au moins 5 x 104 Ω.cm.

18. Chambre de traitement par plasma selon l'une quelconque des revendications 12 à 17, dans laquelle la chemise (30, 60, 62) se compose de parties cylindriques et/ou coniques.

19. Chambre de traitement par plasma selon la revendication 16, dans laquelle l'autre surface à nu est définie par la plaque de distribution qui a une résistivité suffisamment élevée pour faire de la plaque de distribution de gaz un matériau isolant et la chemise (30, 60, 62) ayant une résistivité suffisamment basse pour rendre la chemise (30, 60, 62) électroconductrice.

20. Chambre de traitement par plasma selon l'une quelconque des revendications 12 à 19, dans laquelle la chemise (30, 60, 62), la plaque de distribution, le déflecteur et/ou la bague de focalisation se composent essentiellement de SiC déposé par CVD, fritté, pressé à chaud ou lié par réaction ou d'un composite, dans laquelle un revêtement de SiC forme la surface à nu de ceux-ci.

21. Chambre de traitement par plasma selon l'une quelconque des revendications 12 à 20, dans laquelle la chemise (30, 60, 62), la plaque de distribution, la bague de focalisation et/ou le déflecteur ont une masse volumique d'au moins 3,1 g/cm³ et comprennent au moins 99% en poids de carbone et de silicium.
